# EUROPEAN PATENT SPECIFICATION

(11) **EP 4 184 710 B1**
(45) Date of publication and mention of the grant of the patent: **14.05.2025**
(21) Application number: 22202803.7
(22) Date of filing: 20.10.2022
(51) Int. Cl.: H01Q 1/22, B60C 23/04, G06K 19/077, H01Q 1/12, H01Q 1/36, H01Q 1/38, H01Q 9/16, H01Q 9/42

(54) **ANTENNA CONNECTION FOR INTEGRATED RFID TAG AND TPMS SENSOR**
ANTENNENVERBINDUNG FÜR INTEGRIERTES RFID-ETIKETT UND TPMS-SENSOR
CONNEXION D'ANTENNE POUR ÉTIQUETTE RFID INTÉGRÉE ET CAPTEUR TPMS

(30) Priority: 22.11.2021 US 202163281893 P
(43) Date of publication of application: 24.05.2023
(73) Proprietor: The Goodyear Tire & Rubber Company, Akron, OH 44316 (US)
(72) Inventor: LIN, Cheng-Hsiung, Hudson, 44236 (US)
(74) Representative: Kutsch, Bernd

(56) References cited:
- WO-A1-2009/134243
- CN-A- 103 887 594
- CN-B- 106 329 134
- FR-A1- 3 108 402
- US-A- 5 894 292
- US-A1- 2005 088 361

## Description

### Field of the Invention

The invention relates to tires and components for tires. More particularly, the invention relates to components for tire identification and the monitoring of tire pressure. Specifically, the invention is directed to an integrated radio frequency identification tag and tire pressure monitoring system sensor that includes an antenna connection to a printed circuit board which provides secure and consistent placement and alignment of the antenna for optimum performance.

### Background of the Invention

Pneumatic tires have been widely employed. Such tires include a pair of beads that are mounted on a wheel or rim. Each one of pair of sidewalls extends from a respective bead to a ground-engaging tread. A carcass, which is made of one or more plies, toroidally extends between the beads to reinforce the sidewalls and the tread. An innerliner is formed on the inside surface of the carcass. The wheel cooperates with the innerliner to define an interior or tire cavity that is inflated with air.

It has been desirable to provide such pneumatic tires with an electronic device that enables information about the tire to be transmitted to an external device for tracking of certain parameters and identification of the tire during its lifetime. One such electronic device is a radio frequency identification (RFID) device, sometimes referred to as an RFID tag.

Most RFID tags include an integrated circuit for storing and processing information and an antenna for receiving and transmitting a signal to an external reader using a radio frequency. The antenna is electronically connected to the integrated circuit and typically is carried on a substrate with the integrated circuit, such as a circuit board.

In the prior art, RFID tags were attached to the exterior of a sidewall of a pneumatic tire. The exterior of a tire sidewall provides a convenient location that enables strong transmission of the signal from the RFID tag to an RFID reader, which is separate from the tire. However, the RFID tag may incur potential damage when it is attached to the exterior of a tire sidewall. To reduce such potential damage, it has become desirable to attach the RFID tag to an interior structure of the tire.

In addition, it is desirable to monitor certain parameters, such as the pressure in the tire cavity, the temperature in the tire cavity and/or the temperature in the tread or another tire component, and to transmit data for those parameters to a device that can record and/or display the data. To this end, tire pressure monitoring systems (TPMS) have been developed. Many TPMS configurations employ a pressure and/or temperature sensor that is mounted to the tire, which is referred to as a TPMS sensor. Due to power and communication requirements of TPMS sensors, TPMS units have been separate from RFID tags. However, mounting of separate TPMS sensors and RFID tags in a tire is undesirable.

To provide more efficient mounting in a tire, an integrated RFID tag and TPMS sensor has been developed. The integrated RFID tag and TPMS sensor includes a printed circuit board and a coil antenna that is electronically attached to the printed circuit board. In the prior art, the antenna coil has been directly placed on the printed circuit board and solder has been applied to bond the antenna to the surface of the printed circuit board. However, the efficiency and performance of the integrated RFID tag and TPMS sensor may be significantly affected by issues encountered with the prior art attachment technique.

For example, it may be difficult to place the coil antenna at a repeatable, exact location on the printed circuit board, creating difficulty in installation and leading to undesirable variation in alignment and antenna length. Such variation in turn may interfere with the performance of the integrated RFID tag and TPMS sensor. In addition, there is limited surface contact between the coil antenna and the surface of the printed circuit board for soldering, which may cause undesirable variation in the strength of the bond between the antenna and the printed circuit board and may decrease the durability of the bond. Further, when two coil antennas are mounted to the printed circuit board, the antennas are typically soldered to separate areas on the surface of the printed circuit board. The separate areas may create a different wave form contact between the two antennas, which may impair the efficiency and performance of the antennas.

As a result, there is a need in the art for an integrated radio frequency identification tag and tire pressure monitoring system sensor that includes an antenna connection to a printed circuit board which provides consistent placement and alignment of the antenna for optimum performance.

US 2005/088361 A1 describes an integrated radio frequency identification tag and tire pressure monitoring system sensor in accordance with the preamble of claim 1.

Other integrated radio frequency identification tag and tire pressure monitoring system sensors are described in US 5,894,292 A1, WO 2009/134243 A1, FR 3 108 402 A1, CN 103 887 594 A and CN 106 329 134 B.

### Summary of the Invention

The invention relates to an integrated radio frequency identification tag and tire pressure monitoring system sensor in accordance with claim 1, and to a tire in accordance with claim 10.

Dependent claims refer to preferred embodiments of the invention.

According to an aspect of an exemplary embodiment of the invention, an integrated radio frequency identification tag and tire pressure monitoring system sensor includes a radio frequency identification tag. The radio frequency identification tag includes an integrated circuit, and a printed circuit board carries the integrated circuit. A tire pressure monitoring system sensor is mounted on the radio frequency identification tag. An antenna includes at least one coil antenna wire, in which the at least one antenna wire is formed in a helical shape and is electrically connected to the integrated circuit. The at least one antenna wire includes a first end that is mounted to the printed circuit board. A mechanical interlock between the first end of the antenna wire and the printed circuit board includes features that secure the first end of the antenna wire to the printed circuit board.

### Definitions

"Axial" and "axially" mean lines or directions that are parallel to the axis of rotation of the tire.

"Circumferential" means lines or directions extending along the perimeter of the surface of the annular tread perpendicular to the axial direction.

"Radial" and "radially" mean lines or directions that are perpendicular to the axis of rotation of the tire.

"RFID" means radio frequency identification.

"TPMS" means a tire pressure monitoring system.

### Brief Description of the Drawings

The invention will be described by way of example and with reference to the accompanying drawings, in which:
Figure 1 is a cross-sectional view of an exemplary pneumatic tire with a first exemplary embodiment of an integrated RFID tag and TPMS sensor of the present invention;
Figure 2A is a plan view of an integrated RFID tag and TPMS sensor of the prior art;
Figure 2B is an enlarged plan view of a portion of the integrated RFID tag and TPMS sensor shown in Figure 2A;
Figure 2C is an end view of the integrated RFID tag and TPMS sensor shown in Figure 2A;
Figure 2D is an enlarged end view of a portion of the integrated RFID tag and TPMS sensor shown in Figure 2C;
Figure 3A is a plan view of a first exemplary embodiment of an integrated RFID tag and TPMS sensor of the present invention;
Figure 3B is an enlarged plan view of a portion of a printed circuit board of the integrated RFID tag and TPMS sensor shown in Figure 3A;
Figure 3C is an end view of a portion of the printed circuit board of the integrated RFID tag and TPMS sensor shown in Figure 3B;
Figure 3D is an enlarged plan view of a portion of an antenna of the integrated RFID tag and TPMS sensor shown in Figure 3A;
Figure 3E is an enlarged plan view of a portion of the integrated RFID tag and TPMS sensor shown in Figure 3A;
Figure 3F is an enlarged end view of a portion of the integrated RFID tag and TPMS sensor shown in Figure 3A;
Figure 4A is a plan view of a second exemplary embodiment of an integrated RFID tag and TPMS sensor of the present invention;
Figure 4B is an enlarged plan view of a portion of a printed circuit board of the integrated RFID tag and TPMS sensor shown in Figure 4A;
Figure 4C is an end view of a portion of the printed circuit board of the integrated RFID tag and TPMS sensor shown in Figure 4B;
Figure 4D is an enlarged plan view of a portion of a printed circuit board and an antenna of the integrated RFID tag and TPMS sensor shown in Figure 4A;
Figure 4E is an enlarged plan view of a portion of the integrated RFID tag and TPMS sensor shown in Figure 4A;
Figure 4F is an enlarged end view of a portion of the integrated RFID tag and TPMS sensor shown in Figure 4A;
Figure 5A is a plan view of a third exemplary embodiment of an integrated RFID tag and TPMS sensor of the present invention;
Figure 5B is an enlarged plan view of a portion of the printed circuit board of the integrated RFID tag and TPMS sensor shown in Figure 5A;
Figure 5C is an end view of a portion of the printed circuit board of the integrated RFID tag and TPMS sensor shown in Figure 5B;
Figure 5D is an enlarged plan view of another portion of the printed circuit board of the integrated RFID tag and TPMS sensor shown in Figure 5A;
Figure 5E is an enlarged plan view of a portion of a printed circuit board and an antenna of the integrated RFID tag and TPMS sensor shown in Figure 5A;
Figure 5F is an enlarged plan view of another portion of a printed circuit board and an antenna of the integrated RFID tag and TPMS sensor shown in Figure 5A;
Figure 5G is an enlarged plan view of a portion of the integrated RFID tag and TPMS sensor shown in Figure 5A;
Figure 5H is an enlarged end view of a portion of the integrated RFID tag and TPMS sensor shown in Figure 5A;
Figure 6A is a plan view of a fourth exemplary embodiment of an integrated RFID tag and TPMS sensor of the present invention;
Figure 6B is an enlarged plan view of a portion of a printed circuit board of the integrated RFID tag and TPMS sensor shown in Figure 6A;
Figure 6C is an end view of a portion of the printed circuit board of the integrated RFID tag and TPMS sensor shown in Figure 6B;
Figure 6D is an enlarged plan view of a portion of the integrated RFID tag and TPMS sensor shown in Figure 6A;
Figure 6E is an enlarged end view of a portion of the integrated RFID tag and TPMS sensor shown in Figure 6A;
Figure 7A is a plan view of a fifth exemplary embodiment of an integrated RFID tag and TPMS sensor of the present invention;
Figure 7B is an enlarged plan view of a portion of a printed circuit board of the integrated RFID tag and TPMS sensor shown in Figure 7A;
Figure 7C is an end view of a portion of the printed circuit board of the integrated RFID tag and TPMS sensor shown in Figure 7B;
Figure 7D is an enlarged plan view of a portion of a printed circuit board and an antenna of the integrated RFID tag and TPMS sensor shown in Figure 7A;
Figure 7E is an enlarged plan view of a portion of the integrated RFID tag and TPMS sensor shown in Figure 7A;
Figure 7F is an enlarged end view of a portion of the integrated RFID tag and TPMS sensor shown in Figure 7A;
Figure 8A is a plan view of a sixth exemplary embodiment of an integrated RFID tag and TPMS sensor of the present invention;
Figure 8B is an enlarged plan view of a portion of a printed circuit board of the integrated RFID tag and TPMS sensor shown in Figure 8A;
Figure 8C is an end view of a portion of the printed circuit board of the integrated RFID tag and TPMS sensor shown in Figure 8B;
Figure 8D is an enlarged plan view of a portion of a printed circuit board and an antenna of the integrated RFID tag and TPMS sensor shown in Figure 8A;
Figure 8E is an enlarged plan view of a portion of the integrated RFID tag and TPMS sensor shown in Figure 8A;
Figure 8F is an enlarged end view of a portion of the integrated RFID tag and TPMS sensor shown in Figure 8A;
Figure 9A is a plan view of a seventh exemplary embodiment of an integrated RFID tag and TPMS sensor of the present invention;
Figure 9B is an enlarged plan view of a portion of a printed circuit board of the integrated RFID tag and TPMS sensor shown in Figure 9A;
Figure 9C is an end view of a portion of the printed circuit board of the integrated RFID tag and TPMS sensor shown in Figure 9B;
Figure 9D is an enlarged plan view of a portion of a printed circuit board and an antenna of the integrated RFID tag and TPMS sensor shown in Figure 9A;
Figure 9E is an enlarged plan view of a portion of the integrated RFID tag and TPMS sensor shown in Figure 9A;
Figure 9F is an enlarged end view of a portion of the integrated RFID tag and TPMS sensor shown in Figure 9A;
Figure 10A is a plan view of an eighth exemplary embodiment of an integrated RFID tag and TPMS sensor of the present invention;
Figure 10B is an enlarged plan view of a portion of a printed circuit board of the integrated RFID tag and TPMS sensor shown in Figure 10A;
Figure 10C is an enlarged plan view of another portion of a printed circuit board of the integrated RFID tag and TPMS sensor shown in Figure 10A;
Figure 10D is an enlarged plan view of a portion of a printed circuit board and an antenna of the integrated RFID tag and TPMS sensor shown in Figure 10A;
Figure 10E is an enlarged plan view of another portion of a printed circuit board and an antenna of the integrated RFID tag and TPMS sensor shown in Figure 10A;
Figure 10F is an enlarged plan view of a portion of the integrated RFID tag and TPMS sensor shown in Figure 10A; and
Figure 10G is an enlarged end view of a portion of the integrated RFID tag and TPMS sensor shown in Figure 10A.

Similar numerals refer to similar parts throughout the drawings.

### Detailed Description of Preferred Embodiments of the Invention

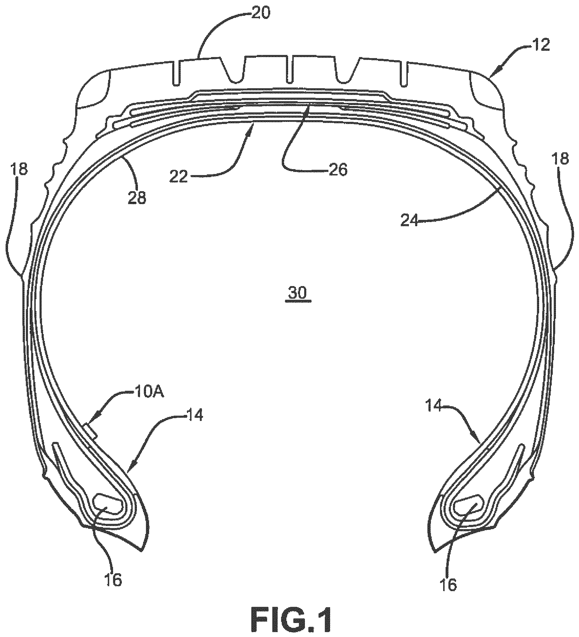

Exemplary embodiments of an integrated RFID tag and TPMS sensor of the present invention are shown in Figures 1 and 3A-10G, and are indicated at 10A-10H, respectively. The integrated RFID tag and TPMS sensor 10A-10H is preferably employed in a tire 12.

For example, referring to Figure 1, a first exemplary embodiment of the integrated RFID tag and TPMS sensor is indicated at 10A. The tire 12 includes a pair of bead areas 14 and a respective bead core 16 embedded in each bead area. A respective sidewall 18 extends radially outward from each bead area 14 to a ground-contacting tread 20. The tire 12 is reinforced by a carcass 22 that toroidally extends from one of the bead areas 12 to the other one of the bead areas. The carcass 20 includes at least one ply 24 that preferably winds around each bead core 16. A belt reinforcement package 26 preferably is disposed between the carcass 22 and the tread 20. An innerliner 28 is formed on the inside surface of the carcass 22. A tire cavity 30 is disposed inwardly of the innerliner 28.

When the tire 12 is mounted on a wheel (not shown) of a vehicle, as known in the art, the innerliner 28 cooperates with the wheel to render the tire cavity 30 airtight. The integrated RFID tag and TPMS sensor 10A preferably is mounted on the innerliner 28 of the tire 12 and is disposed in the tire cavity 30. Of course, all embodiments of the integrated RFID tag and TPMS sensor 10A-10H may be employed in the tire 12.

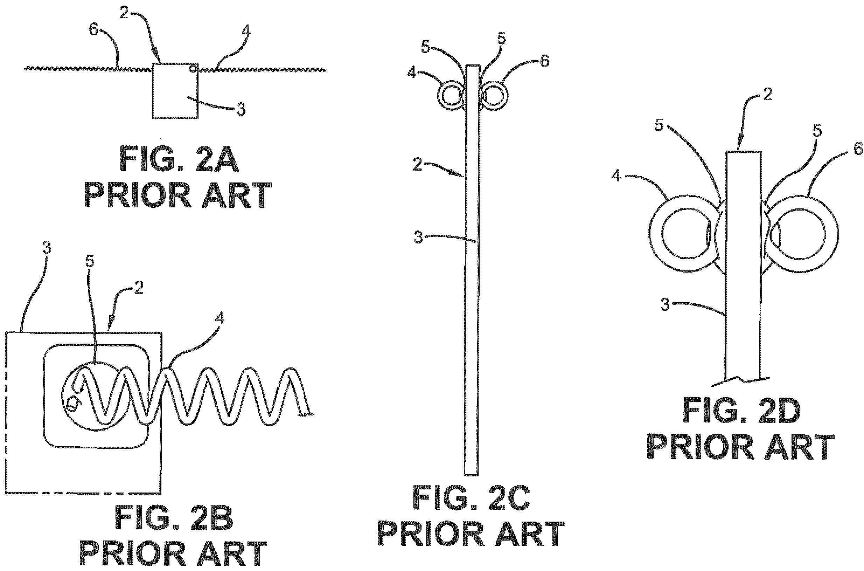

By way of background, turning to Figures 2A-2D, an integrated RFID tag and TPMS sensor of the prior art 2 is shown. The prior art integrated RFID tag and TPMS sensor 2 includes a printed circuit board 3 and a coil antenna 4 that is electronically attached to the printed circuit board. The coil antenna 4 is directly placed on the printed circuit board 3 and solder 5 is applied to bond the antenna to the printed circuit board. This structure may create issues, such as difficulty in placing the coil antenna 4 at a repeatable, exact location on the printed circuit board 3, leading to undesirable variation in alignment and antenna length. There is also limited surface contact between the coil antenna 4 and the printed circuit board 3 for soldering 5, which may cause undesirable variation in the strength of the bond between the antenna and the printed circuit board and a decrease in bond durability. When a second coil antenna 6 is mounted to the printed circuit board 3 with the first coil antenna 4, each antenna is soldered to separate area on the printed circuit board, which may create a different wave form contact between the two antennas that impairs the performance of the antennas.

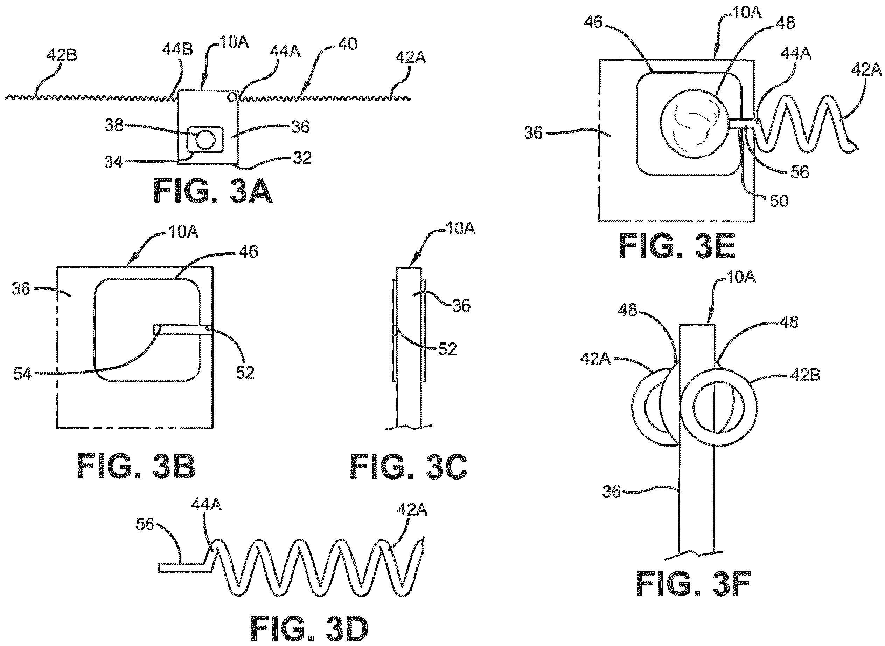

Referring to Figures 3A-3F, the structure of the first exemplary embodiment of the integrated RFID tag and TPMS sensor 10A is shown. The integrated RFID tag and TPMS sensor 10A includes an RFID tag 32, which in turn includes an integrated circuit 34. The integrated circuit 34 is carried on a printed circuit board 36 and processes and stores data for the tire 12. More particularly, the integrated circuit 36 includes electronic memory capacity for storing identification (ID) information for each tire 12, known as tire ID information.

The tire ID information may include manufacturing information for the tire 12, such as: the tire type; tire model; size information, such as rim size, width, and outer diameter; manufacturing location; manufacturing date; a treadcap code that includes or correlates to a compound identification; and a mold code that includes or correlates to a tread structure identification. The tire ID information may also include a service history or other information to identify specific features and parameters of each tire 12, as well as mechanical characteristics of the tire.

The integrated circuit 34 also modulates and demodulates a radio frequency signal for communication with an external reader (not shown) through an antenna 40, which will be described in greater detail below.

A TPMS sensor 38 preferably is mounted on the RFID tag 32, and thus is in electronic communication with the integrated circuit 34 and the antenna 40. The TPMS sensor 38 preferably includes a pressure sensor that measures the pressure in the tire cavity 30, and may include a temperature sensor that measures the temperature in the tire cavity and/or another component of the tire 12. The TPMS sensor 38 may correlate the pressure and temperature measurements. Other sensors may also be mounted on the RFID tag 32, such as a stress sensor, a strain sensor, vibration sensor, accelerometer, and the like.

The antenna 40 preferably includes two coil antenna wires 42a and 42b, which are each formed in a helical shape. The antenna 40 receives and transmits a signal to the external reader using a radio frequency, thus facilitating communication between the integrated RFID tag and TPMS sensor 10A and the reader. The configuration of the RFID tag 32, integrated circuit 34, printed circuit board 36, TPMS sensor 38, and antenna 40 is more fully described in U.S. Patent Application Publication No. 2021/0016614.

Each antenna wire 42a and 42b includes a first end 44a and 44b, respectively, which is mounted to the printed circuit board 36. For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The first embodiment of the integrated RFID tag and TPMS sensor 10A includes a mechanical interlock 50 between the first end 44a of the antenna wire 42a and the printed circuit board 36. The mechanical interlock 50 includes features that secure the first end 44a of the antenna wire 42a to the printed circuit board 36. More particularly, a straight slot 52 is formed in the printed circuit board 36 by milling or another forming technique. The slot 52 does not extend through the entire thickness of the printed circuit board 36. A corresponding straight slot 54 is formed in the solder pad 46, and the first end 44a of the antenna wire 42a is formed with a straight terminus 56. The straight terminus 56 of the antenna wire 42a seats in the aligned slots 52 and 54. In this manner, the printed circuit board 36 receives and mechanically engages the terminus 56 of the antenna wire 42a.

After the straight terminus 56 of the antenna wire 42a is engaged in the slots 52, 54, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The first embodiment of the integrated RFID tag and TPMS sensor 10A thus provides a mechanical interlock 50 between the first end 44a, 44b of each respective antenna 42a, 42b and the printed circuit board 36. The mechanical interlock 50 enables secure, convenient, and repeatable placement of each respective antenna 42a, 42b on the printed circuit board 36. By seating in the slots 52, 54, the length of each antenna wire 42a, 42b is controlled, creating a uniform wave form contact between the first and second antenna wires. The mechanical interlock 50 also enables easy soldering on a flat surface, which increases the durability of the bond between the antenna wires 42a, 42b and the printed circuit board 36.

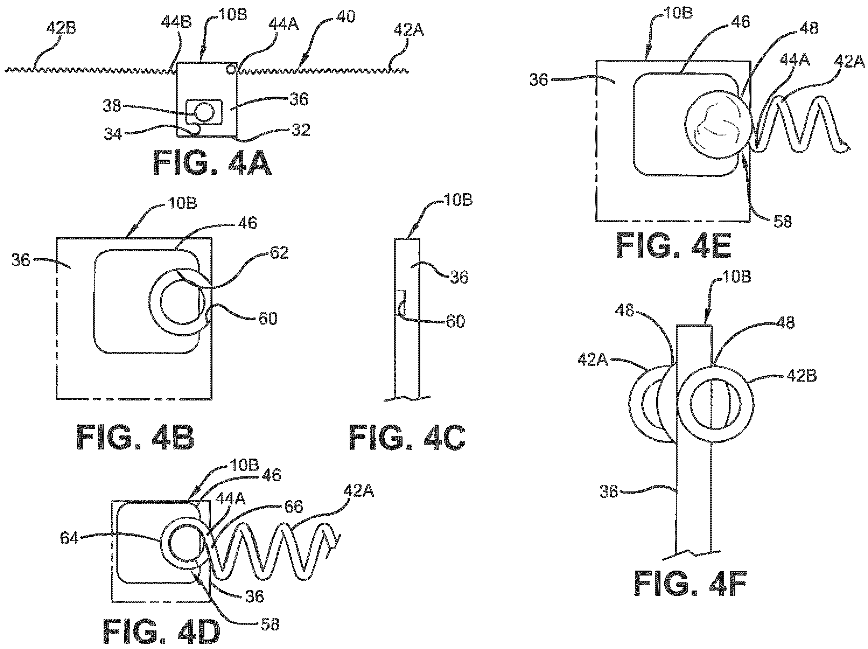

Turning to Figures 4A-4F, the structure of a second exemplary embodiment of the integrated RFID tag and TPMS sensor 10B is shown. The second embodiment of the integrated RFID tag and TPMS sensor 10B includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The second embodiment of the integrated RFID tag and TPMS sensor 10B includes a mechanical interlock 58 between the first end 44a of the antenna wire 42a and the printed circuit board 36. The mechanical interlock 58 includes features that secure the first end 44a of the antenna wire 42a to the printed circuit board 36. More particularly, a circular slot 60 is formed in the printed circuit board 36 by milling or another forming technique. The slot 60 does not extend through the entire thickness of the printed circuit board 36. A corresponding circular slot 62 is formed in the solder pad 46, and the first end 44a of the antenna wire 42a is formed with a circular terminus 56. Preferably, the circular terminus 56 is formed by bending one pitch 66 of the first end 44a of the coiled antenna wire 42a to an angle that is about ninety (90) degrees relative to the remainder of the coiled antenna pitches. The circular terminus 64 of the antenna wire 42a seats in the aligned slots 60 and 62. In this manner, the printed circuit board 36 receives and mechanically engages the terminus 64 of the antenna wire 42a.

After the circular terminus 64 of the antenna wire 42a is engaged in the slots 60, 62, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The second embodiment of the integrated RFID tag and TPMS sensor 10B thus provides a mechanical interlock 58 between the first end 44a, 44b of each respective antenna 42a, 42b and the printed circuit board 36. The mechanical interlock 58 enables secure, convenient, and repeatable placement of each respective antenna 42a, 42b on the printed circuit board 36. By seating in the slots 60, 62, the length of each antenna wire 42a, 42b is controlled, creating a uniform wave form contact between the first and second antenna wires. The mechanical interlock 58 also enables easy soldering on a flat surface, which increases the durability of the bond between the antenna wires 42a, 42b and the printed circuit board 36.

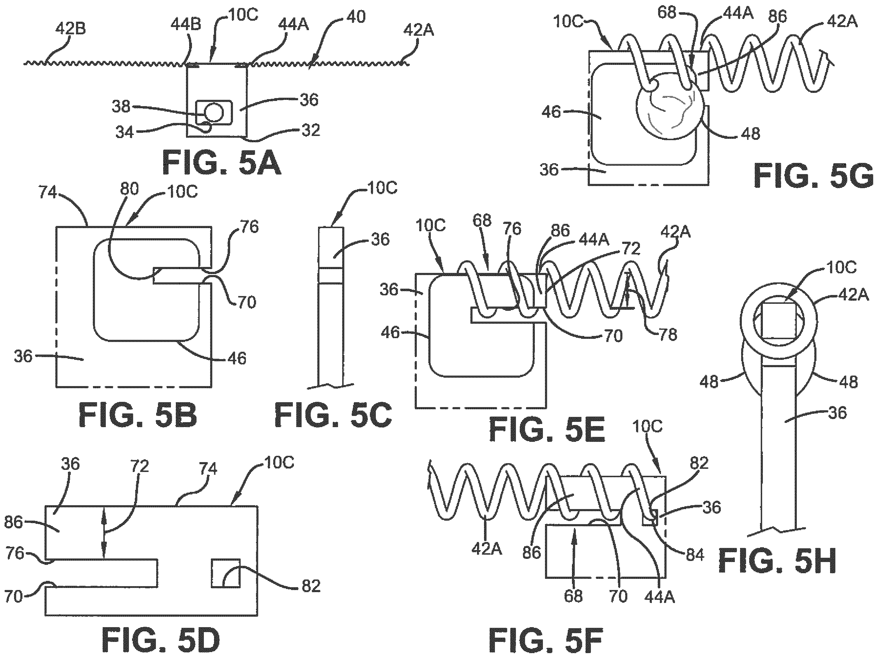

Turning to Figures 5A-5H, the structure of a third exemplary embodiment of the integrated RFID tag and TPMS sensor 10C is shown. The third embodiment of the integrated RFID tag and TPMS sensor 10C includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The third embodiment of the integrated RFID tag and TPMS sensor 10C includes a mechanical interlock 68 between the first end 44a of the antenna wire 42a and the printed circuit board 36. The mechanical interlock 68 includes features that secure the first end 44a of the antenna wire 42a to the printed circuit board 36. More particularly, a straight slot 70 is formed in the printed circuit board 36 by milling or another forming technique. The slot 70 extends through the entire thickness of the printed circuit board 36. The slot 70 is positioned so that a distance between a top edge 74 of the printed circuit board 36 and a top 76 of the slot is less than an inside diameter 78 of the coiled antenna wire 42, creating an insert 86. A straight slot 80 is formed in the solder pad 46 and aligns with the slot 70 in the printed circuit board 36. A recess 82 is formed in the printed circuit board 36 near the straight slot 70, and does not extend through the thickness of the printed circuit board.

The first end 44a of the antenna wire 42a includes a terminus 84. The first end 44a of the antenna wire 42a engages the insert 86 of the printed circuit board 36, and the terminus 84 seats in the recess 82. In this manner, the printed circuit board 36 receives and mechanically engages the first end 44a and the terminus 84 of the antenna wire 42a. After the first end 44a of the antenna wire 42a engages the insert 86 of the printed circuit board 36, and the terminus 84 seats in the recess 82, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The third embodiment of the integrated RFID tag and TPMS sensor 10C thus provides a mechanical interlock 68 between the first end 44a, 44b of each respective antenna 42a, 42b and the printed circuit board 36. The mechanical interlock 68 enables secure, convenient, and repeatable placement of each respective antenna 42a, 42b on the printed circuit board 36. The interlock 68 also enables the length of each antenna wire 42a, 42b to be controlled, creating a uniform wave form contact between the first and second antenna wires. The mechanical interlock 68 further enables easy soldering, which increases the durability of the bond between the antenna wires 42a, 42b and the printed circuit board 36.

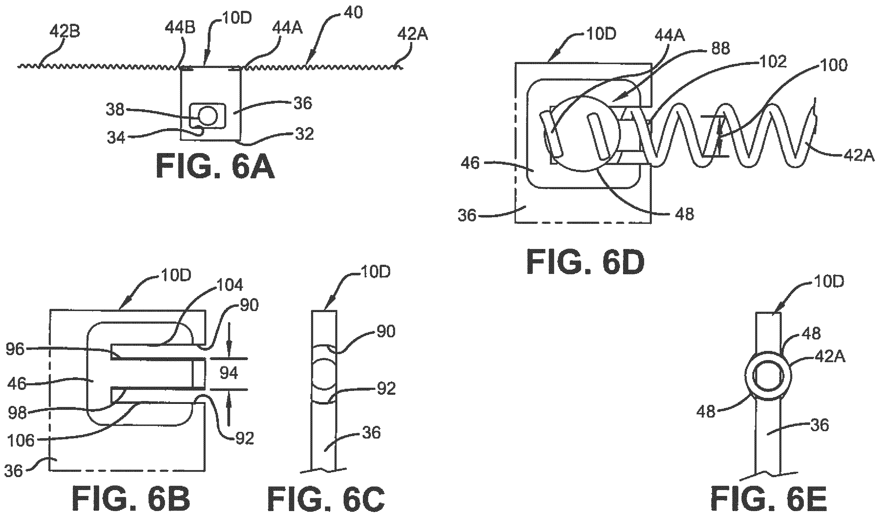

Turning to Figures 6A-6E, the structure of a fourth exemplary embodiment of the integrated RFID tag and TPMS sensor 10D is shown. The fourth embodiment of the integrated RFID tag and TPMS sensor 10D includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The fourth embodiment of the integrated RFID tag and TPMS sensor 10D includes a mechanical interlock 88 between the first end 44a of the antenna wire 42a and the printed circuit board 36. The mechanical interlock 88 includes features that secure the first end 44a of the antenna wire 42a to the printed circuit board 36.

More particularly, a first slot 90 is formed in the printed circuit board 36 by milling or another forming technique. The first slot 90 extends in a straight manner across the printed circuit board 36, with a semi-circular cross section through the entire thickness of the printed circuit board 36. A second slot 92 is formed in the printed circuit board 36 by milling or another forming technique. The second slot 92 extends in a straight manner across the printed circuit board 36 parallel to the first slot 90, with a semi-circular cross section through the entire thickness of the printed circuit board 36. The slots 90 and 92 are of an equal length, and are positioned so that a distance 94 between a bottom edge 96 of the first slot and a top edge 98 of the second slot is less than an inside diameter 100 of the coiled antenna wire 42, creating an insert 102. A first slot 104 is formed in the solder pad 46 in alignment with the first slot 90 in the printed circuit board 36, and a second slot 106 is formed in the solder pad in alignment with the second slot 92 in the printed circuit board.

The first end 44a of the antenna wire 42a engages the insert 102 of the printed circuit board 36. In this manner, the printed circuit board 36 receives and mechanically engages the first end 44a of the antenna wire 42a. After the first end 44a of the antenna wire 42a engages the insert 102 of the printed circuit board 36, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The fourth embodiment of the integrated RFID tag and TPMS sensor 10D thus provides a mechanical interlock 88 between the first end 44a, 44b of each respective antenna 42a, 42b and the printed circuit board 36. The mechanical interlock 88 enables secure, convenient, and repeatable placement of each respective antenna 42a, 42b on the printed circuit board 36. The interlock 88 also enables the length of each antenna wire 42a, 42b to be controlled, creating a uniform wave form contact between the first and second antenna wires. The mechanical interlock 88 further enables easy soldering, which increases the durability of the bond between the antenna wires 42a, 42b and the printed circuit board 36.

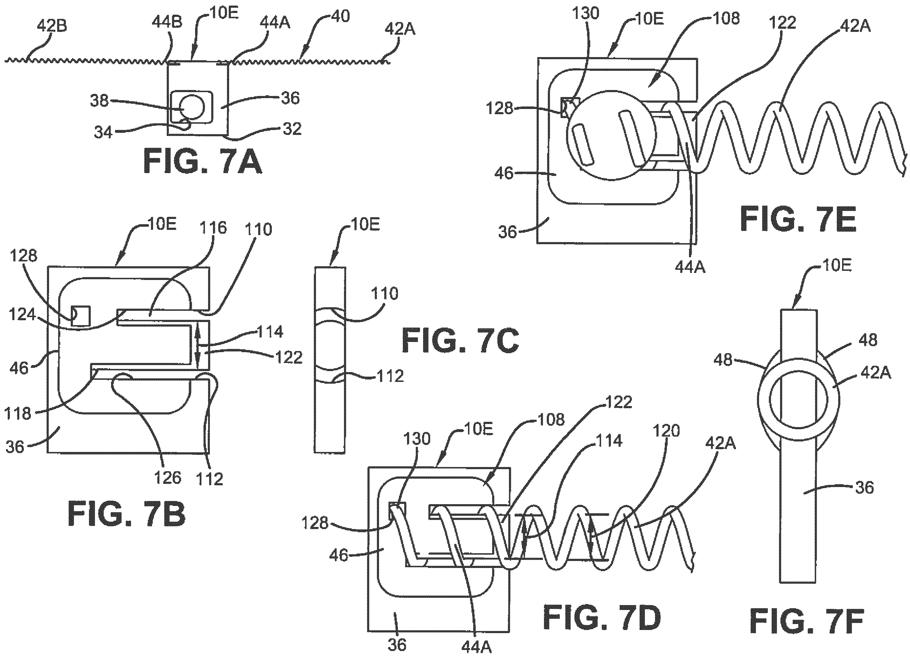

Turning to Figures 7A-7F, the structure of a fifth exemplary embodiment of the integrated RFID tag and TPMS sensor 10E is shown. The fifth embodiment of the integrated RFID tag and TPMS sensor 10E includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The fifth embodiment of the integrated RFID tag and TPMS sensor 10E includes a mechanical interlock 108 between the first end 44a of the antenna wire 42a and the printed circuit board 36. The mechanical interlock 108 includes features that secure the first end 44a of the antenna wire 42a to the printed circuit board 36.

More particularly, a first slot 110 is formed in the printed circuit board 36 by milling or another forming technique. The first slot 110 extends in a straight manner across the printed circuit board 36, with a semi-circular cross section through the entire thickness of the printed circuit board 36. A second slot 112 is formed in the printed circuit board 36 by milling or another forming technique. The second slot 112 extends in a straight manner across the printed circuit board 36 parallel to the first slot 110, with a semi-circular cross section through the entire thickness of the printed circuit board 36. The second slot 112 is formed with a length that is greater than a length of the first slot 110. The slots 110 and 112 are positioned so that a distance 114 between a bottom edge 116 of the first slot and a top edge 118 of the second slot is less than an inside diameter 120 of the coiled antenna wire 42, creating an insert 122. A first slot 124 is formed in the solder pad 46 in alignment with the first slot 110 in the printed circuit board 36, and a second slot 126 is formed in the solder pad in alignment with the second slot 112 in the printed circuit board.

A recess 128 is formed in the printed circuit board 36 near the first slot 110, and does not extend through the thickness of the printed circuit board. The first end 44a of the antenna wire 42a includes a terminus 130. The first end 44a of the antenna wire 42a engages the insert 122 of the printed circuit board 36, and the terminus 130 seats in the recess 128. In this manner, the printed circuit board 36 receives and mechanically engages the first end 44a and the terminus 130 of the antenna wire 42a. After the first end 44a of the antenna wire 42a engages the insert 122 of the printed circuit board 36, and the terminus 130 seats in the recess 128, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The fifth embodiment of the integrated RFID tag and TPMS sensor 10E thus provides a mechanical interlock 108 between the first end 44a, 44b of each respective antenna 42a, 42b and the printed circuit board 36. The mechanical interlock 108 enables secure, convenient, and repeatable placement of each respective antenna 42a, 42b on the printed circuit board 36. The interlock 108 also enables the length of each antenna wire 42a, 42b to be controlled, creating a uniform wave form contact between the first and second antenna wires. The mechanical interlock 108 further enables easy soldering, which increases the durability of the bond between the antenna wires 42a, 42b and the printed circuit board 36.

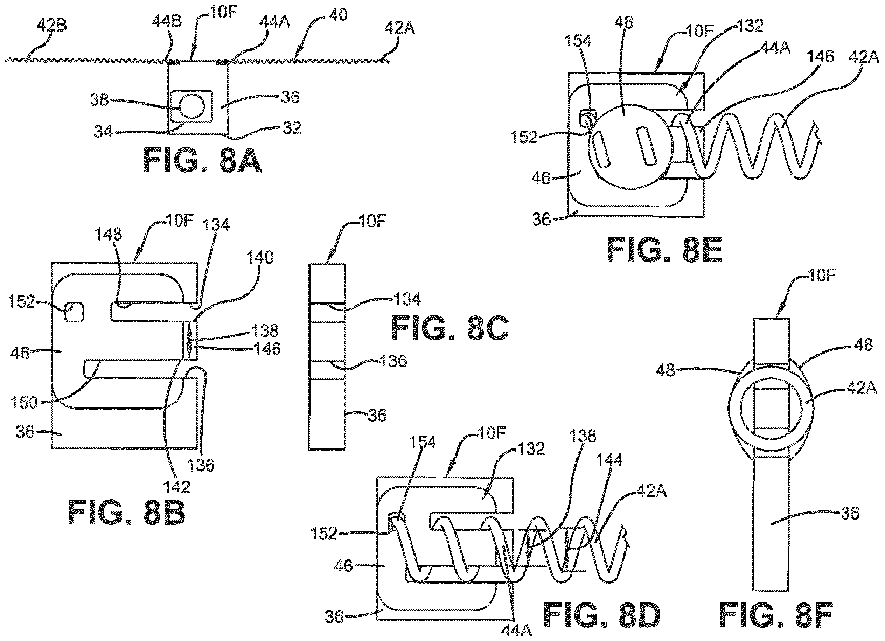

Turning to Figures 8A-8F, the structure of a sixth exemplary embodiment of the integrated RFID tag and TPMS sensor 10F is shown. The sixth embodiment of the integrated RFID tag and TPMS sensor 10F includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The sixth embodiment of the integrated RFID tag and TPMS sensor 10F includes a mechanical interlock 132 between the first end 44a of the antenna wire 42a and the printed circuit board 36. The mechanical interlock 132 includes features that secure the first end 44a of the antenna wire 42a to the printed circuit board 36.

More particularly, a first slot 134 is formed in the printed circuit board 36 by milling or another forming technique. The first slot 134 extends in a straight manner across the printed circuit board 36, with a straight cross section through the entire thickness of the printed circuit board 36. A second slot 136 is formed in the printed circuit board 36 by milling or another forming technique. The second slot 136 extends in a straight manner across the printed circuit board 36 parallel to the first slot 134, with a straight cross section through the entire thickness of the printed circuit board 36. The second slot 136 is formed with a length that is greater than a length of the first slot 134. The slots 134 and 136 are positioned so that a distance 138 between a bottom edge 140 of the first slot and a top edge 142 of the second slot is less than an inside diameter 144 of the coiled antenna wire 42, creating an insert 146. A first slot 148 is formed in the solder pad 46 in alignment with the first slot 134 in the printed circuit board 36, and a second slot 150 is formed in the solder pad in alignment with the second slot 136 in the printed circuit board.

A recess 152 is formed in the printed circuit board 36 near the first slot 134, and does not extend through the thickness of the printed circuit board. The first end 44a of the antenna wire 42a includes a terminus 154. The first end 44a of the antenna wire 42a engages the insert 146 of the printed circuit board 36, and the terminus 154 seats in the recess 152. In this manner, the printed circuit board 36 receives and mechanically engages the first end 44a and the terminus 154 of the antenna wire 42a. After the first end 44a of the antenna wire 42a engages the insert 146 of the printed circuit board 36, and the terminus 154 seats in the recess 152, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The sixth embodiment of the integrated RFID tag and TPMS sensor 10F thus provides a mechanical interlock 132 between the first end 44a, 44b of each respective antenna 42a, 42b and the printed circuit board 36. The mechanical interlock 132 enables secure, convenient, and repeatable placement of each respective antenna 42a, 42b on the printed circuit board 36. The interlock 132 also enables the length of each antenna wire 42a, 42b to be controlled, creating a uniform wave form contact between the first and second antenna wires. The mechanical interlock 132 further enables easy soldering, which increases the durability of the bond between the antenna wires 42a, 42b and the printed circuit board 36.

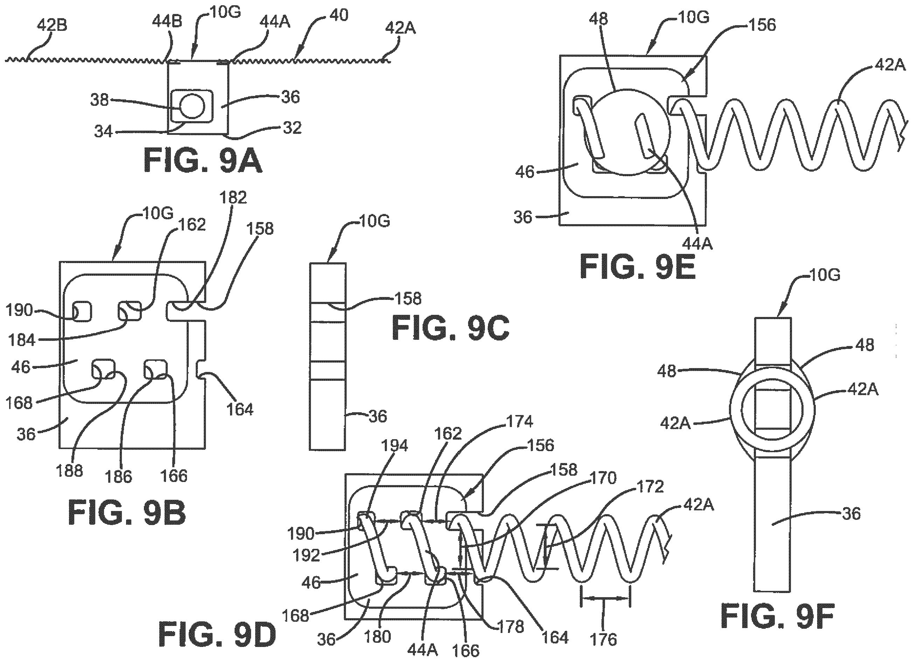

Turning to Figures 9A-9F, the structure of a seventh exemplary embodiment of the integrated RFID tag and TPMS sensor 10G is shown. The seventh embodiment of the integrated RFID tag and TPMS sensor 10G includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The seventh embodiment of the integrated RFID tag and TPMS sensor 10G includes a mechanical interlock 156 between the first end 44a of the antenna wire 42a and the printed circuit board 36. The mechanical interlock 156 includes features that secure the first end 44a of the antenna wire 42a to the printed circuit board 36. More particularly, a first slot 158 is formed in the printed circuit board 36 by milling or another forming technique. The first slot 134 extends in a straight manner into the printed circuit board 36, with a straight cross section through the entire thickness of the printed circuit board 36. A first opening 162 is formed in the printed circuit board 36 in parallel alignment with the first slot 134, and extends through the printed circuit board. A distance 174 between the first slot 158 and the first opening 162 matches a pitch 176 of the coiled antenna wire 42a.

A second slot 164 is formed in the printed circuit board 36 by milling or another forming technique. The second slot 164 extends into the printed circuit board 36 parallel to the first slot 158 for a distance that is less than the first slot, with a straight cross section through the entire thickness of the printed circuit board. The second slot 164 is formed with a length that is less than or shorter than a length of the first slot 158. A second opening 166 is formed in the printed circuit board 36 in parallel alignment with the second slot 164, and extends through the printed circuit board. A third opening 168 is formed in the printed circuit board 36 in parallel alignment with the second slot 164 and the second opening 166, and extends through the printed circuit board. A distance 178 between the second slot 164 and the second opening 166 matches the pitch 176 of the coiled antenna wire 42a, and a distance 180 between the second opening 166 and the third opening 168 also matches the pitch of the coiled antenna wire.

The first slot 158 and the first opening 162 are spaced apart from the second slot 164, the second opening 166, and the third opening 168, creating a distance 170 that is slightly less than an inside diameter 172 of the coiled antenna wire 42. A slot 182 is formed in the solder pad 46 in alignment with the first slot 158 in the printed circuit board 36, a first opening 184 is formed in the solder pad in alignment with the first opening 162, a second opening 186 is formed in the solder pad in alignment with the second opening 166, and a third opening 188 is formed in the solder pad in alignment with the third opening 168.

A recess 190 is formed in the printed circuit board 36 parallel to and near the first opening 162, and does not extend through the thickness of the printed circuit board. A distance 192 between the first opening 162 and the recess 190 matches the pitch 176 of the coiled antenna wire 42a. The first end 44a of the antenna wire 42a includes a terminus 194. This structure enables the first end 44a of the antenna wire 42a to wind through the first slot 158, the second slot 164, the first opening 162, the second opening 166, and the third opening 168, with the terminus 194 seating in the recess 190. In this manner, the printed circuit board 36 receives and mechanically engages the first end 44a and the terminus 194 of the antenna wire 42a.

After the first end 44a of the antenna wire 42a engages the first slot 158, the second slot 164, the first opening 162, the second opening 166, and the third opening 168, and the terminus 194 seats in the recess 190, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The seventh embodiment of the integrated RFID tag and TPMS sensor 10G thus provides a mechanical interlock 156 between the first end 44a, 44b of each respective antenna 42a, 42b and the printed circuit board 36. The mechanical interlock 156 enables secure, convenient, and repeatable placement of each respective antenna 42a, 42b on the printed circuit board 36. The interlock 156 also enables the length of each antenna wire 42a, 42b to be controlled, creating a uniform wave form contact between the first and second antenna wires. The mechanical interlock 156 further enables easy soldering, which increases the durability of the bond between the antenna wires 42a, 42b and the printed circuit board 36.

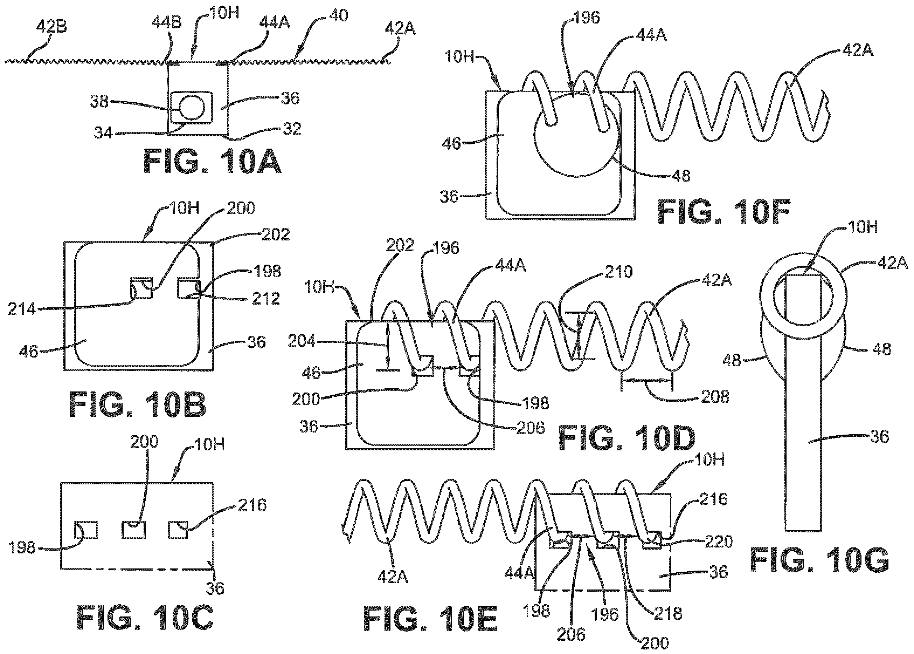

Turning to Figures 10A-10G, the structure of an eighth exemplary embodiment of the integrated RFID tag and TPMS sensor 10H is shown. The eighth embodiment of the integrated RFID tag and TPMS sensor 10H includes an RFID tag 32, integrated circuit 34, printed circuit board 36, TPMS sensor 38, and antenna 40 in a configuration that is similar to the description provided above for the first embodiment of the integrated RFID tag and TPMS sensor 10A. The antenna 40 also includes a first antenna wire 42a and a second antenna wire 42b, each of which includes a first end 44a and 44b, respectively, also as described above.

For the purpose of convenience, the connection of the first antenna wire 42a to the printed circuit board 36 will be described, with the understanding that the description also applies to the connection of the second antenna wire 42b to the printed circuit board. A solder pad 46 preferably is formed on the printed circuit board 36, and the first end 44a of the antenna 42a is mounted to the solder pad with solder 48. The first end 44a of the antenna 42a is electrically connected to the integrated circuit 34 through conductive traces on the printed circuit board 36 that extend between the solder pad 46 and the integrated circuit.

The eighth embodiment of the integrated RFID tag and TPMS sensor 10H includes a mechanical interlock 196 between the first end 44a of the antenna wire 42a and the printed circuit board 36. The mechanical interlock 196 includes features that secure the first end 44a of the antenna wire 42a to the printed circuit board 36. More particularly, a first opening 198 is formed in the printed circuit board 36 by milling or another forming technique, and extends through the printed circuit board. A second opening 200 is formed in the printed circuit board 36 in parallel alignment with the first opening 198, and extends through the printed circuit board. A distance 206 between the first opening 198 and the second opening 200 matches a pitch 208 of the coiled antenna wire 42a.

The first opening 198 and the second opening 200 are spaced apart from a top edge 202 of the printed circuit board 36, creating a distance 204 that is slightly less than an inside diameter 210 of the coiled antenna wire 42. A first opening 212 is formed in the solder pad 46 in alignment with the first opening 198 in the printed circuit board 36, and a second opening 214 is formed in the solder pad in alignment with the second opening 214. A recess 216 is formed in the printed circuit board 36 parallel to and near the second opening 200, and does not extend through the thickness of the printed circuit board. A distance 218 between the second opening 200 and the recess 216 matches the pitch 208 of the coiled antenna wire 42a. The first end 44a of the antenna wire 42a includes a terminus 220.

This structure enables the first end 44a of the antenna wire 42a to wind over the top edge 202 of the printed circuit board 36, through the first opening 198, and through the second opening 200, with the terminus 220 seating in the recess 216. In this manner, the printed circuit board 36 receives and mechanically engages the first end 44a and the terminus 220 of the antenna wire 42a. After the first end 44a of the antenna wire 42a engages the top edge 202 of the printed circuit board 36, the first opening 198, and the second opening 200, and the terminus 220 seats in the recess 216, the solder 48 preferably is deposited on the solder pad 46 to secure the connection of the antenna wire to the printed circuit board 36. As mentioned above, the second antenna wire 42b is connected to the printed circuit board 36 in the same manner as the first antenna wire 42a.

The eighth embodiment of the integrated RFID tag and TPMS sensor 10H thus provides a mechanical interlock 196 between the first end 44a, 44b of each respective antenna 42a, 42b and the printed circuit board 36. The mechanical interlock 196 enables secure, convenient, and repeatable placement of each respective antenna 42a, 42b on the printed circuit board 36. The interlock 196 also enables the length of each antenna wire 42a, 42b to be controlled, creating a uniform wave form contact between the first and second antenna wires. The mechanical interlock 196 further enables easy soldering, which increases the durability of the bond between the antenna wires 42a, 42b and the printed circuit board 36.

In this manner, the integrated RFID tag and TPMS sensor 10A-10H of the present invention employs a structure that includes an antenna connection to a printed circuit board 36 which provides consistent placement and alignment of the antenna 40 for optimum performance. The printed circuit board 36 includes features that guide the antenna coil 44a, 44b for optimum placement, thereby simplifying repeatable antenna placement. The features preferably are formed in the printed circuit board 36 during manufacture of the board, desirably eliminating the need for special forming tools or processes.

The mechanical interlock of the integrated RFID tag and TPMS sensor 10A-10H of the present invention includes features that ensure consistent and repeatable installation of each respective antenna 42a, 42b on the printed circuit board 36, which in turn ensures performance of the antenna. The mechanical interlock features of the integrated RFID tag and TPMS sensor 10A-10H also enable the length of each antenna wire 42a, 42b to be controlled, creating a uniform wave form contact between the first and second antenna wires. The mechanical interlock features further enable easy soldering, which increases the durability of the bond between the antenna wires 42a, 42b and the printed circuit board 36.

## Claims

1. An integrated radio frequency identification tag and tire pressure monitoring system sensor comprising:
a radio frequency identification tag (32), the radio frequency identification tag including an integrated circuit (34);
a printed circuit board (36) carrying the integrated circuit;
a tire pressure monitoring system sensor (38) being mounted on the radio frequency identification tag;
an antenna (40) including at least one coil antenna wire (42A, 42B), the at least one antenna wire being formed in a helical shape and being electrically connected to the integrated circuit (34);
the at least one antenna wire (42A, 42B) including a first end (44A) that is mounted to the printed circuit board (36); and
a mechanical interlock (50) between the first end (44A) of the antenna wire (42A, 42B) and the printed circuit board (36), the mechanical interlock (50) including one or more features securing the first end (44A) of the antenna wire (42A, 42B) to the printed circuit board (36),
**characterized in that**
**(i)** the one or more features include a circular slot formed in the printed circuit board (36), wherein the first end (44A) of the antenna wire (42A, 42B) is formed with a circular terminus that seats in the circular slot; or
**(ii)** the one or more features include:
a first slot formed in the printed circuit board (36), the first slot extending through a thickness of the printed circuit board;
a second slot formed in the printed circuit board (36) parallel to the first slot, the second slot extending through the thickness of the printed circuit board;
wherein the first and second slots are positioned to create an insert (86) between them that is less than an inside diameter of the antenna wire (42A, 42B), and the first end (44A) of the antenna wire engages the insert; or
**(iii)** the one or more features include:
a first slot formed in the printed circuit board (36) and extending through a thickness of the printed circuit board;
a first opening formed in the printed circuit board in parallel alignment with the first slot and extending through the thickness of the printed circuit board, wherein a distance between the first slot and the first opening matches a pitch of the antenna wire (42A, 42B);
a second slot formed in the printed circuit board (36) and extending through the thickness of the printed circuit board;
a second opening formed in the printed circuit board in parallel alignment with the second slot and extending through the thickness of the printed circuit board; and
a third opening formed in the printed circuit board (36) in parallel alignment with the second slot and the second opening extending through the thickness of the printed circuit board;
wherein a distance between the second slot and the second opening matches the pitch of the antenna wire (42A, 42B), and a distance between the second opening and the third opening matches the pitch of the antenna wire (42A, 42B); and
wherein the first end (44A) of the antenna wire (42A, 42B) winds through the first slot, the second slot, the first opening, the second opening, and the third opening; or
(iv) the one or features include:
a first opening formed in the printed circuit board (36) and extending through a thickness of the printed circuit board;
a second opening formed in the printed circuit board (36) in parallel alignment with the first opening and extending through the thickness of the printed circuit board;
wherein a distance between the first opening and the second opening matches a pitch of the antenna wire (42A, 42B);
wherein the first end (44A) of the antenna wire (42A, 42B) winds through the first opening, over a top edge of the printed circuit board (36), and through the second opening;
wherein a recess (190) is formed in the printed circuit board (36) parallel to and near the second opening that does not extend through the thickness of the printed circuit board (36); and
wherein the first end (44a) of the antenna wire (42A, 42B) includes a terminus that seats in the recess (190).

2. The integrated radio frequency identification tag and tire pressure monitoring system sensor of claim 1, wherein in alternative (i) the circular slot does not extend through an entire thickness of the printed circuit board (36).

3. The integrated radio frequency identification tag and tire pressure monitoring system sensor of claim 2, wherein the circular terminus is formed by bending one pitch of the first end (44A) of the antenna wire (42A, 42B) to an angle that is 90 ninety degrees or in a range of from 80 to 100 degrees relative to a remainder of antenna pitches.

4. The integrated radio frequency identification tag and tire pressure monitoring system sensor of claim 1, wherein in alternative (ii) the first slot and the second slot are formed with equal lengths or wherein the second slot is formed with a length that is longer than a length of the first slot.

5. The integrated radio frequency identification tag and tire pressure monitoring system sensor of claim 4, wherein the first slot includes a first slot semi-circular cross section and the second slot includes a second slot semi-circular cross section, or wherein the first slot includes a first slot straight cross section and the second slot includes a second slot straight cross section.

6. The integrated radio frequency identification tag and tire pressure monitoring system sensor of claim 4 or 5, wherein a recess (190) is formed in the printed circuit board (36) near the first slot that does not extend through the thickness of the printed circuit board, and wherein the first end (44A) of the antenna wire (42A, 42B) includes a terminus that seats in the recess (82).

7. The integrated radio frequency identification tag and tire pressure monitoring system sensor of claim 1, wherein in alternative (iii) a recess (190) is formed in the printed circuit board (36) parallel to and near the first opening that does not extend through the thickness of the printed circuit board, and the first end (44A) of the antenna wire (42A, 42B) includes a terminus that seats in the recess (190).

8. The integrated radio frequency identification tag and tire pressure monitoring system sensor of at least one of the previous claims, further comprising a solder pad (46) formed on the printed circuit board (36), wherein the first end (44A) of the antenna (40) is mounted to the solder pad (46) with solder.

9. The integrated radio frequency identification tag and tire pressure monitoring system sensor of at least one of the previous claims, further comprising a pneumatic tire (12), the integrated radio frequency identification tag and tire pressure monitoring system sensor (10A) being mounted to the pneumatic tire (12).

10. A pneumatic tire comprising the integrated radio frequency identification tag and tire pressure monitoring system sensor (10A) according to at least one of the claims 1 to 9 mounted to a surface of said tire (12) or integrated into said tire (12).

## Patentansprüche

1. Sensor eines Systems zur Überwachung des Drucks eines Luftreifens und Radiofrequenz-Identifikationsetikett im integrierten Zustand, wobei der Sensor das Folgende umfasst:
ein Radiofrequenz-Identifikationsetikett (32); wobei das Radiofrequenz-Identifikationsetikett eine integrierte Schaltung (34) umfasst;
eine Leiterplatte (36), die den integrierten Schaltkreis trägt;
einen Sensor (38) eines Systems zur Überwachung des Drucks des Reifens, der an dem Radiofrequenz-Identifikationsetikett angebracht ist;
eine Antenne (40), die mindestens einen spiralförmigen Antennendraht (42A, 42B) umfasst, wobei der mindestens eine Antennendraht in einer schlangenförmigen Konfiguration ausgebildet ist und elektrisch mit der integrierten Schaltung (34) verbunden ist;
wobei der mindestens eine Antennendraht (42A, 42B) ein erstes Ende (44) umfasst, das an der Leiterplatte (36) angebracht ist;
ein mechanisches Element (50), das eine Verriegelung zwischen dem ersten Ende (44A) des Antennendrahts (42A, 42B) und der Leiterplatte (36) bereitstellt, wobei das mechanische Element (50), das eine Verriegelung bereitstellt, ein oder mehrere Merkmale umfasst, die das erste Ende (44A) des Antennendrahts (42A, 42B) an der Leiterplatte (36) befestigen;
**dadurch gekennzeichnet, dass**
(i) das eine oder die mehreren Merkmale einen kreisförmigen Schlitz umfassen, der in der Leiterplatte (36) ausgebildet ist; wobei das erste Ende (44A) des Antennendrahts (42A, 42B) mit einem kreisförmigen Abschluss versehen ist, der in den kreisförmigen Schlitz eingreift; oder
(ii) das eine oder die mehreren Merkmale das Folgende umfassen:
einen ersten Schlitz, der in der Leiterplatte (36) ausgebildet ist, wobei der erste Schlitz sich durch eine Dicke der Leiterplatte erstreckt;
einen zweiten Schlitz, der in der Leiterplatte (36) ausgebildet ist, der parallel zum ersten Schlitz ist, wobei der zweite Schlitz sich durch die Dicke der Leiterplatte erstreckt;
wobei der erste und der zweite Schlitz so angebracht sind, dass zwischen ihnen ein Einschub (86) entsteht, der kleiner ist als ein Innendurchmesser des Antennendrahts (42A, 42B), und das erste Ende (44A) des Antennendrahts in den Einschub eingreift; oder
(iii) das eine oder die mehreren Merkmale das Folgende umfassen:
einen ersten Schlitz, der in der Leiterplatte (36) ausgebildet ist und sich durch eine Dicke der Leiterplatte erstreckt;
eine erste Öffnung, die in der Leiterplatte ausgebildet ist, die parallel zu dem ersten Schlitz ausgerichtet ist und sich durch die Dicke der Leiterplatte erstreckt; wobei ein Abstand zwischen dem ersten Schlitz und der ersten Öffnung einer Neigung des Antennendrahts (42A, 42B) entspricht;
einen zweiten Schlitz, der in der Leiterplatte (36) ausgebildet ist und sich durch die Dicke der Leiterplatte erstreckt;
eine zweite Öffnung in der Leiterplatte, die parallel zu dem zweiten Schlitz ausgerichtet ist und sich durch die Dicke der Leiterplatte erstreckt; und
eine dritte Öffnung in der Leiterplatte (36), die parallel zu dem zweiten Schlitz ausgerichtet ist; wobei die zweite Öffnung sich durch die Dicke der Leiterplatte erstreckt;
wobei ein Abstand zwischen dem zweiten Schlitz und der zweiten Öffnung der Neigung des Antennendrahts (42A, 42B) entspricht und ein Abstand zwischen der zweiten Öffnung und der dritten Öffnung der Neigung des Antennendrahts (42A, 42B) entspricht; und
wobei das erste Ende (44A) des Antennendrahts (42A, 42B) durch den ersten Schlitz, den zweiten Schlitz, die erste Öffnung, die zweite Öffnung und die dritte Öffnung gewickelt wird; oder
(IV) das eine oder die mehreren Merkmale das Folgende umfassen:
eine erste Öffnung, die in der Leiterplatte (36) ausgebildet ist und sich durch eine Dicke der Leiterplatte erstreckt;
eine zweite Öffnung, die in der Leiterplatte (36) ausgebildet ist, die parallel zu der ersten Öffnung ausgerichtet ist und sich durch die Dicke der Leiterplatte erstreckt;
wobei ein Abstand zwischen der ersten Öffnung und der zweiten Öffnung einer Neigung des Antennendrahts (42A, 42B) entspricht;
wobei das erste Ende (44A) des Antennendrahts (42A, 42B) durch die erste Öffnung über eine obere Kante der Leiterplatte (36) und durch die zweite Öffnung gewickelt wird;
wobei eine Aussparung (190) in der Leiterplatte parallel zu und in der Nähe der zweiten Öffnung ausgebildet ist, die sich nicht durch die Dicke der Leiterplatte (36) erstreckt; und
wobei das erste Ende (44A) des Antennendrahts (42A, 42B) einen Abschluss umfasst, der in die Aussparung (190) passt.

2. Sensor eines Systems zur Überwachung des Drucks eines Reifens und Radiofrequenz-Identifikationsetikett im integrierten Zustand nach Anspruch 1, wobei in der Variante (i), der kreisförmige Schlitz sich nicht über die gesamte Dicke der Leiterplatte (36) erstreckt.

3. Sensor eines Systems zur Überwachung des Drucks eines Luftreifens und Radiofrequenz-Identifikationsetikett im integrierten Zustand nach Anspruch 2, wobei der kreisförmige Abschluss durch Biegen einer Neigung des ersten Endes (44A) des Antennendrahts (42A, 42B) bis zu einem Winkel hergestellt wird, der 90 Grad beträgt oder der in einem Bereich von 80 bis 100 Grad in Bezug auf die verbleibenden Neigungen der Antenne liegt.

4. Sensor eines Systems zur Überwachung des Drucks eines Luftreifens und Radiofrequenz-Identifikationsetikett im integrierten Zustand nach Anspruch 1, wobei in der Variante (ii), der erste Schlitz und der zweite Schlitz mit gleichen Längen ausgeführt sind; oder wobei der zweite Schlitz mit einer Länge ausgeführt ist, die größer ist als eine Länge des ersten Schlitzes.

5. Sensor eines Systems zur Überwachung des Drucks eines Luftreifens und Radiofrequenz-Identifikationsetikett im integrierten Zustand nach Anspruch 4, wobei der erste Schlitz einen ersten halbkreisförmigen Querschnitt umfasst und der zweite Schlitz einen zweiten halbkreisförmigen Querschnitt umfasst; oder wobei der erste Schlitz einen ersten geradlinigen Querschnittsschlitz umfasst und der zweite Schlitz einen zweiten geradlinigen Querschnittsschlitz umfasst.

6. Sensor eines Systems zur Überwachung des Drucks eines Luftreifens und Radiofrequenz-Identifikationsetikett im integrierten Zustand nach Anspruch 4 oder 5, wobei eine Aussparung (190) so in der Leiterplatte (36) in der Nähe des ersten Schlitzes in einer solchen Weise vorgesehen ist, dass sie sich nicht durch die Dicke der Leiterplatte erstreckt; und wobei das erste Ende (44A) des Antennendrahts (42A, 42B) einen Abschluss umfasst, der in die Aussparung (190) passt.

7. Sensor eines Systems zur Überwachung des Drucks eines Reifens und Radiofrequenz-Identifikationsetikett im integrierten Zustand nach Anspruch 1, wobei in der Variante (iii), in der Leiterplatte (36) parallel und in der Nähe der ersten Öffnung eine Aussparung (190) vorgesehen ist, die sich nicht über die gesamte Dicke der Leiterplatte erstreckt, und das erste Ende (44A) des Antennendrahts (42A, 42B) einen Abschluss umfasst, der in die Aussparung (190) passt.

8. Sensor eines Systems zur Überwachung des Drucks eines Luftreifens und Radiofrequenz-Identifikationsetikett im integrierten Zustand gemäß mindestens einem der vorhergehenden Ansprüche, der ferner ein Lötpad (46) umfasst, das auf der Leiterplatte (36) ausgebildet ist; wobei das erste Ende (44) der Antenne (40) an dem Lötpad (46) mit einem Lötmittel angebracht ist.

9. Sensor eines Systems zur Überwachung des Drucks eines Luftreifens und Radiofrequenz-Identifikationsetikett im integrierten Zustand nach mindestens einem der vorhergehenden Ansprüche, wobei das System ferner einen Reifen (12) umfasst, wobei der Sensor eines Systems zur Überwachung des Drucks eines Luftreifens und das Radiofrequenz-Identifikationsetikett im integrierten Zustand (10A) an dem Reifen (12) angebracht sind.

10. Luftreifen, der den Sensor eines Reifendrucküberwachungssystems und das Radiofrequenz-Identifikationsetikett im integrierten Zustand (10A) gemäß mindestens einem der Ansprüche 1 bis 9 umfasst, die an einer Oberfläche des Reifens (12) angebracht sind oder die in den Reifen (12) integriert sind.

## Revendications

1. Capteur d'un système de surveillance de la pression d'un bandage pneumatique et étiquette d'identification par radiofréquence à l'état intégré, dans lequel le capteur comprend :
une étiquette d'identification par radiofréquence (32) ; dans lequel l'étiquette d'identification par radiofréquence englobe un circuit intégré (34) ;
une carte de circuits imprimés (36) qui supporte le circuit intégré ;
un capteur (38) de système de surveillance de la pression du bandage pneumatique, qui est monté sur l'étiquette d'identification par radiofréquence ;
une antenne (40) qui englobe au moins un fil d'antenne hélicoïdale (42A, 42B), dans lequel ledit au moins un fil d'antenne est réalisé en une configuration sous la forme d'un serpentin et est raccordé par voie électrique ou circuit intégré (34) ;
ledit au moins un fil d'antenne (42A, 42B) englobant une première extrémité (44) qui est montée sur la carte de circuits imprimés (36 ;
un élément mécanique procurant un verrouillage réciproque (50) entre la première extrémité (44A) et fil d'antenne (42A, 42B) et la carte de circuits imprimés (36), dans lequel l'élément mécanique procurant un verrouillage réciproque (50) englobe une ou plusieurs caractéristiques qui fixent la première extrémité (44A) du fil d'antenne (42A, 42B) à la carte de circuits imprimés (36) ;
**caractérisé en ce que**
(i) lesdites une ou plusieurs caractéristiques englobent une fente circulaire qui est formée dans la carte de circuits imprimés (36) ; dans lequel la première extrémité (44A) du fil d'antenne (42A, 42B) est réalisée avec une terminaison de forme circulaire qui vient s'insérer dans la fente circulaire ; ou
(ii) lesdites une ou plusieurs caractéristiques englobent :
une première fente formée dans la carte de circuits imprimés (36), dans lequel la première fente s'étend à travers une épaisseur de la carte de circuits imprimés ;
une deuxième fente formée dans la carte de circuits imprimés (36), qui est mise en parallèle avec la première fente, dans lequel la deuxième fente s'étend à travers l'épaisseur de la carte de circuits imprimés ;
dans lequel la première et la deuxième fente sont disposées dans le but de créer une insertion (86) entre elles, qui est inférieure à un diamètre interne du fil d'antenne (42A, 42B), et la première extrémité (44A) du fil d'antenne vient s'insérer dans l'insertion ; ou
(iii) lesdites une ou plusieurs caractéristiques englobent :
une première fente formée dans la carte de circuits imprimés (36) et qui s'étend à travers une épaisseur de la carte de circuits imprimés ;
une première ouverture pratiquée dans la carte de circuits imprimés, qui est mise en alignement parallèle avec la première fente et qui s'étend à travers l'épaisseur de la carte de circuits imprimés ; dans lequel une distance entre la première fente et la première ouverture correspond à un pas du fil d'antenne (42A, 42B) ;
une deuxième fente formée dans la carte de circuits imprimés (36) et qui s'étend à travers l'épaisseur de la carte de circuits imprimés ;
une deuxième ouverture pratiquée dans la carte de circuits imprimés, qui est mise en alignement parallèle avec la deuxième fente et qui s'étend à travers l'épaisseur de la carte de circuits imprimés ; et
une troisième ouverture pratiquée dans la carte de circuits imprimés (36), qui est mise en alignement parallèle avec la deuxième fente ; et dans lequel la deuxième ouverture s'étend à travers l'épaisseur de la carte de circuits imprimés ;
dans lequel une distance entre la deuxième fente et la deuxième ouverture correspond ou pas du fil d'antenne (42A, 42B), et une distance entre la deuxième ouverture et la troisième ouverture correspond ou pas du fil d'antenne (42A, 42B) ; et
dans lequel la première extrémité (44A) du fil d'antenne (42A, 42B) s'enroule à travers la première fente, la deuxième fente, la première ouverture, la deuxième ouverture et la troisième ouverture ; ou
(IV) lesdites une ou plusieurs caractéristiques englobent :
une première ouverture formée dans la carte de circuits imprimés (36) et qui s'étend à travers une épaisseur de la carte de circuits imprimés ;
une deuxième ouverture formée dans la carte de circuits imprimés (36) qui est mise en alignement parallèle avec la première ouverture et qui s'étend travers l'épaisseur de la carte de circuits imprimés ;
dans lequel une distance entre la première ouverture et la deuxième ouverture correspond à un pas du fil d'antenne (42A, 42B) ;
dans lequel la première extrémité (44A) du fil d'antenne (42A, 42B) s'enroule à travers la première ouverture par-dessus un bord supérieur de la carte de circuits imprimés (36), et à travers la deuxième ouverture ;
dans lequel un évidement (190) est formé dans la carte de circuits imprimés qui est en parallèle avec et à proximité de la deuxième ouverture, qui ne s'étend pas à travers l'épaisseur de la carte de circuits imprimés (36) ; et
dans lequel la première extrémité (44A) du fil d'antenne (42A, 42B) englobe une terminaison qui vient s'insérer dans l'évidement (190).

2. Capteur d'un système de surveillance de la pression d'un bandage pneumatique et étiquette d'identification par radiofréquence à l'état intégré selon la revendication 1, dans lequel, dans la variante (i), la fente circulaire ne s'étend pas sur la totalité de l'épaisseur de la carte de circuits imprimés (36).

3. Capteur d'un système de surveillance de la pression d'un bandage pneumatique et étiquette d'identification par radiofréquence à l'état intégré selon la revendication 2, dans lequel la terminaison circulaire est obtenue par pliage d'un pas de la première extrémité (44A) du fil d'antenne (42A, 42B) jusqu'à l'obtention d'un angle qui s'élève à 90 degrés ou qui se situe dans une plage allant de 80 à 100 degrés par rapport aux pas de l'antenne qui restent.

4. Capteur d'un système de surveillance de la pression d'un bandage pneumatique et étiquette d'identification par radiofréquence à l'état intégré selon la revendication 1, dans lequel, dans la variante (ii), la première fente et la deuxième fente sont réalisées avec des longueurs égales ; ou dans lequel la deuxième fente est réalisée avec une longueur qui est supérieure à une longueur de la première fente.

5. Capteur d'un système de surveillance de la pression d'un bandage pneumatique et étiquette d'identification par radiofréquence à l'état intégré selon la revendication 4, dans lequel la première fente englobe une première section transversale de forme semi-circulaire et la deuxième fente englobe une deuxième section transversale de forme semi-circulaire ; ou dans lequel la première fente englobe une première fente de section transversale rectiligne et la deuxième fente englobe une deuxième fente de section transversale rectiligne.

6. Capteur d'un système de surveillance de la pression d'un bandage pneumatique et étiquette d'identification par radiofréquence à l'état intégré selon la revendication 4 ou 5, dans lequel un évidement (190) est prévu dans la carte de circuits imprimés (36) à proximité de la première fente, d'une manière telle qu'il ne s'étend pas à travers l'épaisseur de la carte de circuits imprimés ; et dans lequel la première extrémité (44A) du fil d'antenne (42A, 42B) englobe une terminaison qui vient s'insérer dans l'évidement (190).

7. Capteur d'un système de surveillance de la pression d'un bandage pneumatique et étiquette d'identification par radiofréquence à l'état intégré selon la revendication 1, dans lequel, dans la variante (iii), un évidement (190) est prévu dans la carte de circuits imprimés (36) qui est mise en parallèle avec et à proximité de la première ouverture, qui ne s'étend pas sur la totalité de l'épaisseur de la carte de circuits imprimés, et la première extrémité (44A) du fil d'antenne (42A, 42B) englobe une terminaison qui vient s'insérer dans l'évidement (190).

8. Capteur d'un système de surveillance de la pression d'un bandage pneumatique et étiquette d'identification par radiofréquence à l'état intégré selon au moins une des revendications précédentes, qui comprend en outre un plot de soudure (46) qui est formé sur la carte de circuits imprimés (36) ; dans lequel la première extrémité (44) de l'antenne (40) est montée sur le plot de soudure (46) avec un métal d'apport de brasage.

9. Capteur d'un système de surveillance de la pression d'un bandage pneumatique et étiquette d'identification par radiofréquence à l'état intégré selon au moins une des revendications précédentes, qui comprend en outre un bandage pneumatique (12), dans lequel le capteur d'un système de surveillance de la pression d'un bandage pneumatique et l'étiquette d'identification par radiofréquence à l'état intégré (10A) sont montés sur le bandage pneumatique (12).

10. Bandage pneumatique qui comprend le capteur d'un système de surveillance de la pression d'un bandage pneumatique et l'étiquette d'identification par radiofréquence à l'état intégré (10A) en conformité avec au moins une des revendications 1 à 9, qui sont montés sur une surface dudit bandage pneumatique (12) qui sont intégrés dans ledit bandage pneumatique (12).
